# EUROPÄISCHE PATENTSCHRIFT

(11) **EP 1 857 827 B1**
(45) Veröffentlichungstag und Bekanntmachung des Hinweises auf die Patenterteilung: **20.11.2013**
(21) Anmeldenummer: 07008192.2
(22) Anmeldetag: 23.04.2007
(51) Int. Cl.: G01R 31/28

(54) **Schaltungsanordnung mit einer seriellen Testschnittstelle bzw. serielles Testbetriebsverfahren**
Circuit device with serial test interface and serial test mode procedure
Circuit à interface de test sériel et procédé à mode de test sériel

(30) Priorität: 15.05.2006 DE 102006022985
(43) Veröffentlichungstag der Anmeldung: 21.11.2007
(73) Patentinhaber: Micronas GmbH, 79108 Freiburg i. Br. (DE)
(72) Erfinder: Bidenbach, Reiner, 79279 Vörstetten (DE); Franke, Jörg, 79117 Freiburg (DE); Ritter, Joachim, 79540 Lörrach (DE); Jung, Christian, 79263 Simonswald (DE)
(74) Vertreter: Koch Müller Patentanwaltsgesellschaft mbH

(56) Entgegenhaltungen:
- EP-A2- 0 084 247
- EP-A2- 0 687 916
- DE-A1-102004 010 852
- DE-C1- 19 819 265
- US-B1- 6 292 009

## Beschreibung

Die Erfindung bezieht sich auf eine Schaltungsanordnung mit einer seriellen Testschnittstelle mit den oberbegrifflichen Merkmalen gemäß Patentanspruch 1 bzw. auf ein serielles Testbetriebsverfahren zum Betreiben insbesondere einer solchen Testschnittstelle.

DE 198 19 265 C1 beschreibt ein Verfahren zum Parametrieren einer integrierten Schaltungsanordnung sowie eine integrierte Schaltungsanordnung dafür. Ausgegangen wird dabei von einer integrieren Schaltungsanordnung, welche im Wesentlichen fest verdrahtete bzw. fest verbundene Komponenten aufweist. Durch eine Parametrisierung können Parameter für den Betrieb der Schaltungsanordnung vorgegeben werden. Zur Eingabe der Parameter dient ein Versorgungsspannungsanschluss, an welchem eine Versorgungsspannung anliegt. Die eigentlichen Parameter werden der Versorgungsspannung aufmoduliert, wobei ein dem Versorgungsspannungsanschluss nachgeschalteter Komparator die anliegende Versorgungsspannung daraufhin prüft, ob diese über einen Schwellenwert hinaus ansteigt. Der Schwellenwert liegt dabei einpegelig oberhalb der für den Betrieb erforderlichen Versorgungsspannung der integrierten Schaltungsanordnung. Außerdem umfasst die integrierte Schaltungsanordnung gemäß bestimmter Ausführungsformen einen Hall-Sensor zum Erfassen eines Magnetfelds, welches auf die integrierte Schaltungsanordnung einwirkt. Mittels des Sensors erfasste Daten werden über einen analogen Ausgangsanschluss ausgegeben.

Allgemein bekannt sind außerdem Gehäuse mit einer großen Vielzahl an Anschlusskontakten in Form von so genannten Pins, wobei die Gehäuse zur Aufnahme von unter anderem integrierten Schaltungskomponenten dienen. Bekannt ist dabei, einen frei programmierbaren digitalen Prozessor mit weiteren für den Betrieb eines Prozessors erforderlichen Komponenten in dem Gehäuse aufzunehmen. Üblicherweise dienen dabei zwei Anschlusskontakte des Gehäuses zum Anlegen einer Versorgungsspannung und einer Basisspannung, zwei weitere Anschlusskontakte zum Anlegen eines Erdanschlusses bzw. einer Null-Spannung und einer Betriebsspannung sowie eine Vielzahl weiterer Anschlusskontakte zum Ein- oder Ausgeben von Daten.

Solche Schaltungsanordnungen und auch sonstige integrierte Schaltungsanordnungen verwenden für Test- bzw. Prüfzwecke entweder nur aus einem entsprechenden Gehäuse geführte Signal-Anschlusskontakte zum parallelen oder seriellen Testen oder Nutzen, sofern nur wenige Anschlusskontakte vorhanden sind, eine einfache einpegelige Modulation der Versorgungsspannung gemäß DE 198 19 265 C1 und/oder eine einfache Modulation der Stromaufnahme.

Um einen schnellen unidirektionalen seriellen und synchronen Test einer integrierten Schaltungsanordnung vornehmen zu können, sind bislang mindestens drei Eingabe-Anschlusskontakte sowie mindestens ein Ausgabe-Anschlusskontakt erforderlich. Mittels der Eingabe-Anschlusskontakte werden ein Betriebsartsignal zum Signalisieren einer Testbetriebsart, ein Taktsignal sowie ein allgemeines Eingabesignal angelegt. Mit Blick auf den Ausgabe-Anschlusskontakt ist eine Modulation der Stromaufnahme möglich. Mit einer einpegeligen Modulation der Versorgungsspannung, zu deren Demodulation in der integrierten Schaltungsanordnung ein Komparator angeordnet ist, kann von den Eingabe-Anschlusskontakten einer gespart werden. Eine Parallelisierung von Festbetriebsverfahren ist über das Bereitstellen weiterer Eingabe- und Ausgabe-Anschlusskontakte möglich.

Um die Anzahl der Anschlusskontakte, welche an einem entsprechenden Gehäuse zum Anschließen der Schaltungsanordnung vorgesehen sind, einzusparen, bestehen verschiedene Möglichkeiten. So kann gemäß einer ersten Möglichkeit auf das Bereitstellen einer speziellen Testbetriebsart verzichtet werden, wodurch dann nur applikative Tests möglich sind. Gemäß einer zweiten Möglichkeit könnte eine Testbetriebsart über das Anlegen eines speziellen seriellen Kennworts nach einem Einschalten bzw. Hochfahren der Leistung an einem Eingabe-Anschluss eingestellt und in einer Registerzelle gespeichert werden. Eine solche Vorgehensweise ist jedoch sehr unsicher, da jedes spezielle Kennwort auch im Allgemein stets vorhandenen Signalrauschen vorkommen kann. Dadurch könnte die integrierte Schaltungsanordnung in der Applikation auch ungewollt in eine Testbetriebsart übergehen. Gemäß einer dritten Möglichkeit könnte ein Eingabe-Anschlusskontakt dadurch gespart werden, dass an Stelle eines von außen angelegten Taktes mit einem internen Takt gearbeitet wird. Bei einer solchen Umsetzung sind jedoch nur asynchrone und damit langsame Übertragungen von Daten möglich, welche von standardisierten Produktionstestern nicht unterstützt werden. Gemäß einer vierten Möglichkeit wird der Ausgabe-Anschlusskontakt als bidirektionaler Eingabe- und Ausgabe-Anschlusskontakt verwendet. Dies bedeutet jedoch, dass weder eine Modulation der Versorgungsspannung noch eine Modulation der Stromaufnahme bidirektional möglich ist und dass außerdem eine bidirektionale Übertragung gegenüber einer unidirektionalen Übertragung auch immer eine Einschränkung hinsichtlich der maximal möglichen Übertragungsfrequenz zur Folge hat.

Aus der EP 0 687 916 A2, der DE 10 2004 010852 A1, der US 6 292 009 B1 und der EP 0 84 247 A2 sind Schaltungsanordnungen bekannt, bei welchen unter anderem Signalausgänge nach einem Umschalten in einen Testbetriebsmodus, als Signaleingänge verwendet werden.

Die Aufgabe der Erfindung besteht darin, eine Schaltungsanordnung mit einer seriellen Testschnittstelle bzw. ein serielles Testbetriebsverfahren vorzuschlagen, welche auch bei integrierten Schaltungsanordnungen mit einer reduzierten Anzahl von Anschlusskontakten ohne Verlust von möglichen Funktionalitäten oder Kapazitäten einsetzbar sind.

Diese Aufgabe wird durch die Schaltungsanordnung mit einer seriellen Testschnittstelle mit den Merkmalen gemäß Patentanspruch 1 bzw. durch ein serielles Testbetriebsverfahren mit den Merkmalen gemäß Patentanspruch 8 gelöst. Vorteilhafte Ausgestaltungen sind Gegenstand von abhängigen Ansprüchen.

Bevorzugt wird dem gemäß eine Schaltungsanordnung mit einer seriellen Test-Schnittstelle zum Ansteuern einer Testbetriebsart, mit einem frei programmierbaren digitalen Prozessor, mit einem Gehäuse zur Aufnahme der Test-Schnittstelle und des Prozessors und mit Anschlusskontakten für einen Daten- und / oder Signalaustausch mit externen Komponenten und Einrichtungen, wobei an einem der Anschlusskontakte eine modulierte Versorgungsspannung anlegbar ist zum Übertragen von Daten und / oder einem Takt unter Verwendung von zumindest zwei Spannungspegeln, welche ansteuerbar sind und ungleich zu einem Versorgungsspannungspegel zum Versorgen der Schaltungsanordnung mit einer Betriebsspannung sind.

Mittels zumindest zweier Komparatoren ist das Über- und / oder Unterschreiten der beiden Spannungspegel bereits detektierbar.

Mittels einer Komparatorschaltung sind vorteilhaft sowohl der Versorgungsspannung aufmodulierte Daten als für die Schaltungsanordnung interne Daten als auch ein der Versorgungss pan-nung aufmodulierter Takt als für die Schaltungsanordnung interner Takt extrahierbar sind. Der interne Takt ist dabei vorteilhaft durch die Schaltungsanordnung oder Komponenten der Schaltungsanordnung in einer Testbetriebsart verwendbar. Dies ermöglicht eine synchrone Übertragung externer Daten für Programmier- und/oder Speicherzwecke in die Schaltungsanordnung, ohne dass dabei eine Synchronisierung der externen Daten auf einem internen Takt der Schaltungsanordnung vorgenommen werden muss.

Eine Schalteinrichtung ist vorteilhaft zum Aktivieren einer Komparatorschaltung und/oder der Test-Schnittstelle in nur einer Testbetriebsart. Dies ermöglicht eine deutliche Reduzierung des Stromverbrauchs in einer normalen Betriebsart der Schaltungsanordnung, da leistungsintensive Komponenten, welche für die normale Betriebsart nicht benötigt werden, von der Spannungsversorgung abgekoppelt werden können.

Eine Speicheranordnung ist vorteilhaft zum Speichern von Basiszuständen zur automatischen Aktivierung der Testbetriebsart nach einem Einschalten und/oder Inbetriebnehmen der Schaltungsanordnung. Eine Deaktivierung der Schaltungsanordnung, beispielsweise im Fall eines Spannungsausfalls oder eines Austausches derartiger Komponenten führt somit dazu, dass in jedem Fall nach einem Einbau oder einem erneuten Einschalten zuerst die Testbetriebsart aktiviert wird, um die Schaltungsanordnung bzw. deren Komponenten zu überprüfen und/oder um die Schaltungsanordnung mit neuen Funktionalitäten zu programmieren.

Ein analoger oder digitaler Sensor, insbesondere Hall-Sensor kann beispielsweise zum Ausbilden einer Sensor-Schaltungsanordnung integriert sein.

Vorteilhaft ist außerdem ein serielles Testbetriebsverfahren für eine solche Schaltungsanordnung, wobei verfahrensgemäß auf eine Versorgungsspannung sowohl externe Daten als auch ein externer Takt aufmoduliert werden zur Übertragung in die Schaltungsanordnung.

Zum Aufmodulieren der Daten und des Takts können insbesondere zwei Spannungspegel zusätzlich zu einem Versorgungsspannungspegel für eine Betriebsspannung der Schaltungsanordnung verwendet werden. Die Daten und der Takt können dabei derart auf die Versorgungsspannung aufmoduliert werden, dass mit jeder zweiten Flanke einer Taktperiode des Takts einer der beiden Spannungspegel über- oder unterschritten wird, wobei die dazwischen liegenden Taktflanken die Versorgungsspannung auf einen Spannungspegel zwischen den beiden Spannungspegeln führen.

Mittels einer vorgegebenen Bit-Folge kann vorteilhaft eine Aktivierung einer Testbetriebsart signalisiert werden.

Mittels der übertragenen Daten können auf einfache Art und Weise Komponenten der Schaltungsanordnung geprüft und/oder neu programmiert werden.

Durch das nicht anspruchsgemäße Einführen bereits nur eines weiteren Spannungspegels, d. h. insbesondere eines zweiten Spannungspegels oberhalb einer Versorgungsspannung können die Funktionen einer Taktübertragung und einer Dateneingabe auf einen Eingabe-Anschlusskontakt reduziert werden. Dadurch ist eine schnelle unidirektionale serielle und synchrone Testbetriebsart umsetzbar, bei welche eine Datenausgabe über einen eigenen Ausgabe-Anschlusskontakt oder über eine Stromaufnahmemodulation umgesetzt werden kann.

Algorithmen und Parameter für eine solche Testbetriebsart können vorzugsweise in einem internen nicht flüchtigen Speicher, beispielsweise in einem EEPROM oder in einem NV-RAM, welches aus einem EEPROM und einem Register bzw. einem RAM gebildet wird, auch über ein Rücksetzen (reset) oder ein Herunterfahren der Leistung gespeichert werden.

Um schon direkt nach dem ersten Hochfahren der Leistung, d. h. nach einer Fertigung des Wafers oder einer Temperaturlagerung in die Testbetriebsart zu schalten, können die Inhalte von vorzugsweise nur zwei nicht flüchtigen Zellen verglichen werden. Eine Testbetriebsart wird immer dann aktiviert, wenn beide Inhalte dieser beiden Zellen gleich sind, d. h. insbesondere den Wert 0 aufweisen. Zur weiteren Parallelisierung eines Tests können weitere Pegel bezüglich der Versorgungsspannung oder einer Stromaufnahme optional eingeführt werden.

Ein Ausführungsbeispiel wird nachfolgend anhand der Zeichnung näher erläutert. Es zeigen:
Fig. 1 eine schematisierte Schnittansicht durch ein Gehäuse mit einer integrierten Schaltungsanordnung und
Fig. 2 Kontaktanschlüssen zur Kontaktierung der im Gehäuse befindlichen Komponenten,
Fig. 3 eine beispielhafte Schaltungsanordnung für einen Komparator zum Extrahieren von Daten und einem Takt aus einer angelegten Versorgungsspannung und
Fig. 4 verschiedene Signal- bzw. Taktverläufe zur Verdeutlichung einer Verfahrensweise zur Modulation bzw. Demodulation einer Versorgungsspannung.

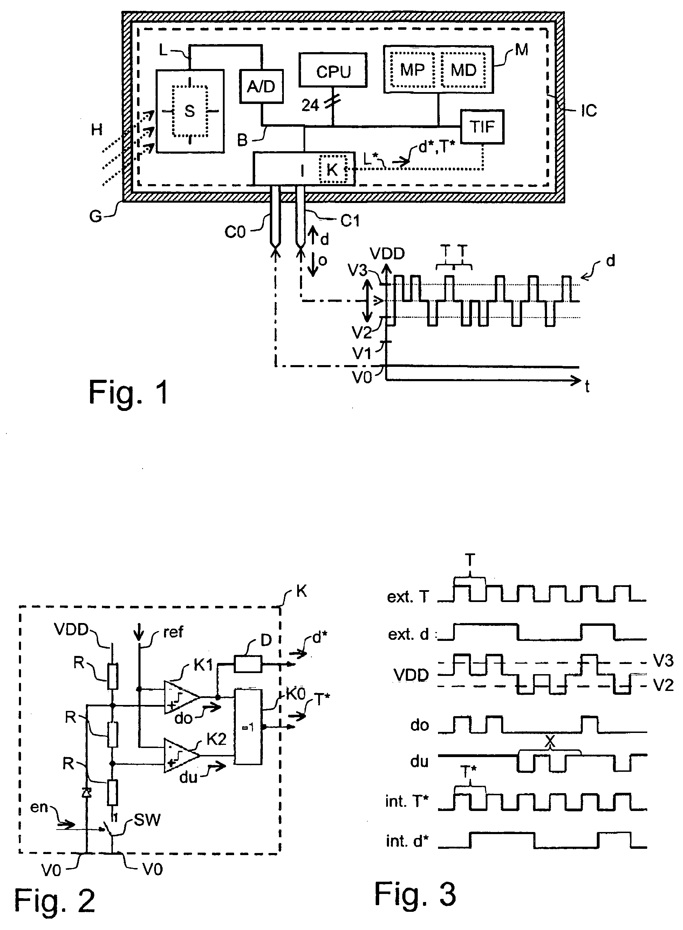

Fig. 1 zeigt schematisch eine Schnittansicht durch ein Gehäuse G eines monolithischen Sensors, wobei die in dem Gehäuse monolithisch integrierten Komponenten lediglich schematisch skizziert sind. Die konkrete Ausgestaltung einer derartigen im Gehäuse G aufgenommenen integrierten Schaltungsanordnung IC kann in für integrierte Schaltungsanordnungen üblicher Art und Weise gefertigt werden. Neben den dargestellten Komponenten können weitere Komponenten in der Schaltungsanordnung integriert sein, welche für den Betrieb dieses monolithischen Sensors in üblicher Art und Weise vorteilhaft oder erforderlich sind.

Das dargestellte Gehäuse G weist zwei Anschlusskontakte C0, C1 zur Kontaktierung der im Gehäuse G befindlichen Komponenten auf. Die Anschlusskontakte C0, C1 sind vorzugsweise als für sich bekannte sogenannte Pins ausgebildet, welche in einen Stecksockel einsetzbar sind. Die Anschlusskontakte C0, C1 führen innerhalb des Gehäuses G in eine Schnittstellenschaltung I. Die Schnittstellenschaltung I setzt Signale bzw. Daten von den Anschlusskontakten C0, C1 auf einen internen Bus B um bzw. in umgekehrter Richtung Daten von dem integrierten Bus B auf einen oder beide der Anschlusskontakte C0, C1 um. Der Bus B ist vorzugsweise als paralleler Bus ausgestaltet, beispielsweise als 8-Bit-Datenbus und 16-Bit-Adressbus. Anstelle eines 24-Bit-Bus für die Adress- und Datenübertragung können natürlich auch getrennte Busse in der integrierten Schaltungsanordnung IC ausgebildet sein. Der Bus B dient dazu, verschiedene in der integrierten Schaltungsanordnung C aufgenommene Komponenten miteinander zu verbinden.

Eine bevorzugte Komponente stellt ein Sensor S dar, wobei beispielhaft ein besonders bevorzugter Kontroll-Sensor zum Erfassen eines den monolithischen Sensor beeinflussenden Magnetfelds H skizziert ist. Um die analogen Signale eines derartigen analogen Sensors S für die Verarbeitung durch weitere Komponenten in digitaler Form bereitstellen zu können, ist der Sensor S über eine Leitung L an einen Analog/Digital-Wandler angeschlossen, welcher die digitalen Daten direkt an einen Prozessor CPU oder über den Bus B an den Prozessor CPU oder weitere Komponenten überträgt.

Der Prozessor CPU ist ein frei programmierbarer digitaler Prozessor und stellt ein weiteres Merkmal des monolithischen Sensors dar. Um einen solchen frei programmierbaren digitalen Prozessor CPU betreiben zu können, ist dieser über den Bus B mit weiteren für dessen Betrieb erforderlichen Komponenten in üblicher Art und Weise verbunden. Insbesondere sind diesbezüglich ein Datenspeicher MD und ein Programmspeicher MP in der integrierten Schaltungsanordnung implementiert. Beispielhaft sind der Datenspeicher MD und der Programmspeicher MP in einer einzigen Speichereinrichtung M aufgenommen, möglich ist jedoch auch eine Ausgestaltung mit eigenständigen Speichereinrichtungen. Neben der Möglichkeit, den Speicher M über den Bus B mit dem Prozessor CPU zu verbinden, besteht zusätzlich oder alternativ auch die Möglichkeit, den Prozessor CPU als Prozessorkern mit direkt angeschlossener Speicherkapazität auszugestalten.

Zum Betreiben der dargestellten integrierten Schaltungsanordnung IC muss dieser eine Versorgungsspannung VDD angelegt werden. Dazu ist der erste der Anschlusskontakte C0 mit einer Basisspannung V0 verbunden und am zweiten der Anschlusskontakte C1 die Versorgungsspannung VDD angelegt. Da die beiden Anschlusskontakte C0, C1 gleichzeitig auch zur Übertragung von Daten verwendet werden, werden die Daten der angelegten Versorgungsspannung VDD aufmoduliert.

Bei dem dargestellten Ausführungsbeispiel wird gemäß dem skizzierten Spannungs-Zeitdiagramm die angelegte Versorgungsspannung VDD über den Verlauf der Zeit t moduliert. Beispielsweise soll als Versorgungsspannung für die integrierte Schaltungsanordnung IC ein erster Versorgungsspannungspegel V1 erforderlich sein. Die Modulation von Daten erfolgt dadurch, dass zur Datenübertragung eine variierende Versorgungsspannung VDD mit einem höheren Spannungspegel als dem ersten Versorgungsspannungspegel V1 angelegt wird. Insbesondere werden zwei oder auch mehr höhere Spannungspegel V2, V3 in ein entsprechendes Protokoll implementiert, so dass nicht nur reine Daten sondern vorzugsweise auch ein Takt P mittels der Versorgungsspannung VDD übertragen werden kann. Die Schnittstellenschaltung I nimmt somit gemäß der bevorzugten Ausführungsform eine Umsetzung einer seriellen Datenübertragung auf eine parallele Datenübertragung vor bzw. in umgekehrter Richtung zur Ausgabe der mittels des Sensors S gemessenen Daten oder sonstiger Daten eine Umsetzung paralleler Daten auf serielle Daten vor. Um die Spannungspegel analysieren zu können, das heißt die mittels der Versorgungsspannung VDD übertragenen Daten d bestimmen zu können, weist die Schnittstellenschaltung I vorzugsweise eine Komparatorschaltung K auf.

Als besonderes Merkmal umfasst die integrierte Schaltungsanordnung gemäß Fig. 1 insbesondere die Komparatorschaltung K und eine Testschnittstelle TFI bzw. Testschnittstellenschaltung. Sowohl die Komparatorschaltung K als auch die Testschnittstelle TIF können vorteilhaft in der Schnittstellenschaltung I integriert oder direkt über eigene Leitungen L* oder einen eigenen Bus daran geschaltet sein.

Fig. 2 zeigt eine beispielhafte Schaltungsanordnung für eine solche Komparatorschaltung K. Angelegt werden insbesondere an entsprechenden Eingängen die Basisspannung V0 und die mit variierendem Pegel anliegende Versorgungsspannung VDD, welche von der Schnittstellenschaltung I und/oder direkt von den beiden Anschlusskontakten C0, C1 abgegriffen werden können. Insbesondere eine im Schaltungsbild skizzierte Diode kann als optionales Element auch entfallen.

Eine Widerstandkette mit drei Widerständen R ist in Reihe geschaltet, wobei ein erster dieser Widerstände R an die Versorgungsspannung VDD geschaltet ist. Ein erster Komparator K1 weist zwei Eingänge auf, wobei an einen positiven Eingang der erste Widerstand und an einen negativen Eingang eine Referenzspannung ref angelegt ist. Die Referenzspannung ref kann beispielsweise ein interner Spannungswert sein, welcher auf mittigem Spannungsniveau zwischen dem zweiten und dem dritten Spannungspegel V2, V3 liegt. Das Referenzsignal ref kann bevorzugt eine intern mit einem Bandgap über Temperatur und Spannung generierte Spannung sein.

Ein zweiter Komparator K2, weist ebenfalls zwei Eingänge auf, wobei der negative Eingang an die Referenzspannung ref geschaltet ist. Der positive Eingang ist an einen Knoten zwischen den aus Sicht der Versorgungsspannung VDD den zweiten und den dritten der Widerstände R geschaltet. Die Ausgänge des ersten und des zweiten Komparators K1, K2, sind an eine Extraktionsschaltung zum Herausziehen des ursprünglichen Taktes T und Bereitstellen eines diesem entsprechenden internen Taktes T* angelegt.

Außerdem ist der Ausgang des ersten Komparators einem Verzögerungslied D angelegt, welches mit zeitlicher Verzögerung die rekonstruierten ursprünglichen Daten d als interne Daten d* bereitstellt. Das Verzögerungsglied D ist so eingestellt, dass die Flanken des Signals für die internen Daten d* nicht mit den Flanken des internen Takts T* zusammenfallen.

Der dritte Widerstand der Widerstände R ist über einen Schalter SW an die Basisspannung V0 schaltbar, wobei zum Schließen des Schalters ein Freigabesignal en zum Aktivieren der Testbetriebsart angelegt wird. Durch das Deaktivieren können die Komparatoren K1, K2 ausgeschaltet werden, wenn sich die integrierte Schaltung IC nicht in der Testbetriebsart befindet, so dass weniger Strom verbraucht wird.

Die Testbetriebsart wird vorzugsweise dadurch aktiviert, dass eine bestimmte Bitfolge in einem vorgegebenen Registerbereich, insbesondere in zwei EEPROM-Zellen, vorliegt oder über den Strom aus übertragenen Daten d, d* eine entsprechende Bitfolge empfangen wird. Vorzugsweise handelt es sich dabei um zwei auf Null gesetzte Bit.

Fig. 3 zeigt beispielhafte Taktdiagramme für verschiedene Signale in einer solchen Schaltungsanordnung. Die erste Zeile zeigt den externen Takt T, welcher auf die Versorgungsspannung VDD aufmoduliert wird. Die zweite Zeile zeigt die externen Daten d, welche auf die Versorgungsspannung VDD aufmoduliert werden. Die dritte Zeile zeigt die Versorgungsspannung VDD mit den externen Daten d und dem externen Takt, welche aufmoduliert sind. Die Modulation wird dabei derart vorgenommen, dass mit jeder zweiten Taktflanke des Takts T, d. h. mit jeder Taktperiode, entweder der zweite Spannungspegel V2 für einen halben Takt unterschritten oder der dritte Spannungspegel V3 für einen halben Takt überschritten wird. Durch eine entsprechende kombinatorische Logik verlaufen die entsprechende Spannungspegel V2, V3 überschreitenden oder unterschreitenden Abschnitte der Versorgungsspannung VDD entsprechend dem hohen oder tiefen Signalverlauf des Signals für die externen Daten d.

Nach der Übertragung in die Komparatorschaltung K ist am Ausgang des ersten Komparators K1, das Signal do der vierten Zeile abgreifbar, welches immer dann einen hohen Takt hat, wenn ein hoher Datenzustand der externen Daten d vorliegt. Die fünfte Zeile zeigt den Signalverlauf du am Ausgang des zweiten Komparators K2, wobei immer dann, wenn die externen Daten d im tiefen Zustand sind, dieses Komparatorausgangssignal des zweiten Komparators K2 entsprechend im tiefen Zustand ist. Aus diesen Ausgangssignalen do, du der beiden Komparatoren K1, K2 werden der interne Takt T* und die internen Daten d* rekonstruiert und für weitere Schaltungskomponenten insbesondere für die Testschnittstelle TIF bereitgestellt.

Die Signalfolge zur Aktivierung der Testbetriebsart kann somit gemäß einer Ausführungsform zusätzlich oder alternativ zu einem Rest oder einer Spannungsunterbrechung den an den beiden Anschlusskontakten C0, C1 angelegten Spannungswerten der Versorgungsspannung VDD entnommen werden. Im Fall einer ersten Inbetriebnahme wird die Testbetriebsart durch die sämtlich auf 0 voreingestellten Registerwerte automatisch aktiviert.

Um ein Abschalten der Komparatorschaltung durch Deaktivieren des Freigabesignals en zu ermöglich, damit der vorzugsweise gesamte Leistungsverbrauch dieses Schaltungsabschnitt auf Null reduziert werden kann, werden die Signalpegel des internen Takts T* und der internen Daten d* für den deaktivierten Zustand vordefiniert. Der Prozessor CPU startet den Betrieb nach dem Einschalten der Leistung dadurch in der Testbetriebsart. Die serielle Testschnittstelle TIF kann in den Rücksetzzustand (reset) schalten und dann die internen Steuerregister modifizieren, beispielsweise den Prozessor CPU deaktivieren, bevor der Rücksetzzustand wieder verlassen wird. Der Prozessor CPU läuft vorzugsweise weiter, wenn ein Umschalten von der Anwenderbetriebsart in die Testbetriebsart vorgenommen wird, bis die serielle Testschnittstelle TIF ein Rücksetzsignal erzeugt. Durch die beschriebene Verfahrensweise zur Modulation der Versorgungsspannung VDD wirkt sich ein mittels der Versorgungsspannung VDD übertragener Befehl in Form entsprechender Datenbit erst nach dem vierten empfangenen Bit aus.

Fig. 1 zeig eine Ausführungsform, bei welcher Ausgabe-Daten o über einen der beiden Anschlusskontakte C1 ausgegeben werden beispielsweise mittels Strommodulation. Gemäß alternativer Ausführungsformen können jedoch auch drei oder mehr Anschlusskontakte vorgesehen werden, insbesondere ein dritter Anschlusskontakt zum Ausgeben von Ausgabedaten o.

Ein Protokoll zur Umsetzung eines entsprechenden seriellen Testbetriebsverfahrens sieht vor, dass der Prozessor CPU und eine eventuell vorhandene interne Taktquelle ausgeschaltet werden können. Durch das Übertragen des externen Takts T in die integrierte Schaltungsanordnung IC findet vorzugsweise eine direkte Synchronisierung der externen Daten d an den derart generierten internen Takt T* statt. Der interne Bus B kann durch ein Schieberegister gesteuert werden, welches seriell beladen wird. Einzugebende Daten d und der Takt T werden über die beschriebene Modulation der Versorgungsspannung VDD eingegeben.

Vorzugsweise ist bei einem beispielhaften Protokoll ein Befehlsfeld drei Bit bzw. drei Takte lang. Interne Merker (Flags) in beispielsweise dem EEPROM wählen eine Systemfrequenz mit beispielsweise 16, 8, 4 oder 2 MHz. Der eingegebene Takt T* für einige periphere Module, beispielsweise eine LIN-UART-Schnittstelle kann durch das Bereitstellen eines entsprechenden Takt-Multiplexers als einer weiteren Komponente der integrierten Schaltungsanordnung bis insbesondere zum generierten internen Takt T* der seriellen Testschnittstelle TIF erzeugt werden. Ein analoges Feld für die Ausgabe von analogen Signalen kann beispielsweise 1,25 µs lang gewählt werden. Falls dies nicht ausreichend sein sollte, kann der Verschiebetakt auch gedehnt werden, um eine Kollision mit einem Synchronisierungsmechanismus zu vermeiden.

Ein weiterer Multiplexer am Ausgabe-Anschlusskontakt kann programmiert werden, einen seriellen Datenstrom oder andere interne analoge oder digitale Signale oder einen internen Takt auszugeben.

Nach einem Rücksetzen wartet die Logik der seriellen Testschnittstelle TIF auf den Empfang einer "1". Dies kann beispielsweise eine führende "1" des Rücksetzbefehls sein. Das 4-te Bit definiert den Pegel des internen Rücksetzsignals.

Gemäß einem derartigen Protokoll können verschiedenartige Befehle implementiert werden, insbesondere ein Rücksetzbefehl, ein Taktübertragungsbefehl, ein Schreib- oder Lese-Befehl für die Testbetriebsart oder ein Lese- oder Schreibbefehl für den Prozessor CPU. Mittels eines derartigen Protokolls kann somit eine Programmierung des Prozessors und/oder eine Modifikation von Speicherinhalten des Programmspeichers MP und/oder des Datenspeichers MD über die Testschnittstelle TIF vorgenommen werden.

## Patentansprüche

1. Schaltungsanordnung mit
einer seriellen Test-Schnittstelle (TIF) zum Ansteuern einer Testbetriebsart,
einem frei programmierbaren digitalen Prozessor (CPU),
einem Gehäuse (G) zur Aufnahme der Test-Schnittstelle (TIF) und des Prozessors (CPU) und Anschlusskontakten (CO, C1) für einen Daten- und/oder Signalaustausch mit externen Komponenten und Einrichtungen,
wobei ein erster Anschlusskontakt (C0) mit einer Basisspannung (V0) und ein zweiter Anschlusskontakt (C1) mit einer Versorgungsspannung (VDD) beaufschlagt ist,
ein erster Komparator (K1) mit zwei Eingängen und ein zweiter Komparator (K2) mit zwei Eingängen vorgesehen ist, und
die Versorgungsspannung (VDD) einen Versorgungsspannungspegel (V1) zum Versorgen der Schaltungsanordnung mit einer Betriebsspannung der Schaltungsanordnung aufweist, wobei
die Versorgungsspannung (VDD) zum Übertragen von Daten (d) und einem Takt (T) unter Verwendung von zumindest zwei Spannungspegeln (V2, V3) modulierbar ist,
beide Spannungspegel (V2, V3) einen höheren Spannungspegel als der Versorgungsspannungspegel (V1) aufweisen,
die modulierbare Versorgungsspannung (VDD) über eine Widerstandskette an dem positiven Eingang des ersten Komparators (K1) und an dem positiven Eingang des zweiten Komparators (K2) anliegt, und
an dem negativen Eingang des ersten Komparators (K1) und an dem negativen Eingang des zweiten Komparator (K2) eine Referenzspannung anliegt.

2. Schaltungsanordnung nach Anspruch 1, bei welcher mittels zumindest der beiden Komparatoren (K1, K2) das Über- und / oder Unterschreiten der beiden Spannungspegel (V2, V3) detektierbar ist.

3. Schaltungsanordnung nach Anspruch 1 oder 2, bei welcher mittels einer Komparatorschaltung (K) sowohl der Versorgungsspannung (VDD) aufmodulierte Daten (d) als für die Schaltungsanordnung interne Daten (d*) als auch ein der Versorgungsspannung (VDD) aufmodulierter Takt (T) als für die Schaltungsanordnung interner Takt (T*) extrahierbar sind.

4. Schaltungsanordnung nach Anspruch 3, bei welcher der interne Takt (T*) durch die Schaltungsanordnung oder Komponenten der Schaltungsanordnung in einer Testbetriebsart verwendet wird.

5. Schaltungsanordnung nach einem vorstehenden Anspruch mit einer Schalteinrichtung (SW) zum Aktivieren einer Komparatorschaltung (K) und/oder der Test-Schnittstelle (TIF) nur in einer Testbetriebsart.

6. Schaltungsanordnung nach Anspruch 5 mit einer Speicheranordnung (M) zum Speichern von Basiszuständen zur automatischen Aktivierung der Testbetriebsart nach einem Einschalten und / oder Inbetriebnehmen der Schaltungsanordnung.

7. Schaltungsanordnung nach einem vorstehenden Anspruch mit einem analogen oder digitalen Hall-Sensor zum Ausbilden einer Sensor-Schaltungsanordnung.

8. Serielles Testbetriebsverfahren mit einer Schaltungsanordnung nach einem vorstehenden Anspruch, bei der auf eine Versorgungsspannung (VDD) sowohl externe Daten (d) als auch ein externer Takt (T) aufmoduliert werden zur Übertragung in die Schaltungsanordnung.

9. Verfahren nach Anspruch 8, bei dem die Daten (d) und der Takt (T) derart auf die Versorgungsspannung (VDD) aufmoduliert werden, dass mit jeder zweiten Flanke einer Taktperiode des Takts (T) einer der beiden Spannungspegel (V2, V3) über- oder unterschritten wird, wobei die dazwischen liegenden Taktflanken die Versorgungsspannung (VDD) auf einen Spannungspegel zwischen den beiden Spannungspegeln (V2, V3) führen.

10. Verfahren nach Anspruch 8 oder Anspruch 9, bei dem mittels einer vorgegebenen Bit-Folge (X) eine Aktivierung einer Testbetriebsart signalisiert wird.

## Claims

1. Circuit arrangement with a serial test interface (TIF) for activating a test mode of operation, a freely programmable digital process (CPU), a housing (G) for receiving the test interface (TIF) and the processor (CPU), and connecting contacts (C0, C1) for data and/or signal exchange with external components and devices,
wherein a first connecting contact (C0) is acted on by a basic voltage (V0) and a second connecting contact (C1) is acted on by a supply voltage (VDD), a first comparator (K1) with two inputs and a second comparator (K2) with two inputs are provided and the supply voltage (VDD) has a supply voltage level (V1) for supply of the circuit arrangement with an operating voltage of the circuit arrangement,
wherein the supply voltage (VDD) for transmission of data (d) and a clock signal (T) can be modulated with use of at least two voltage levels (V2, V3),
the two voltage levels (V2, V3) have a higher voltage level than the supply voltage level (V1),
the modulatable supply voltage (VDD) is applied by way of a resistance chain to the positive input of the first comparator (K1) and to the positive input of the second comparator (K2) and
a reference voltage is applied to the negative input of the first comparator (K1) and to the negative input of the second comparator (K2).

2. Circuit arrangement according to claim 1, in which exceeding and/or falling-below of the two voltage levels (V2, V3) is detectable by means of at least the two comparators (K1, K2).

3. Circuit arrangement according to claim 1 or 2, in which not only data (d), which are modulated on the supply voltage (VDD), as internal data (d*) for the circuit arrangement, but also a clock signal (T), which is modulated on the supply voltage (VDD), as an internal clock signal (T*) for the circuit arrangement can be extracted by means of a comparator circuit (K).

4. Circuit arrangement according to claim 3, in which the internal clock signal (T*) is used by the circuit arrangement or components of the circuit arrangement in a test mode of operation.

5. Circuit arrangement according to any one of the preceding claims with a switching device (SW) for activating a comparator circuit (K) and/or the test interface (TIF) only in a test operating mode.

6. Circuit arrangement according to claim 5 with a memory arrangement (M) for storage of basic states for automatic activation of the test operating mode after switchingon of the circuit arrangement and/or placing the circuit arrangement in operation.

7. Circuit arrangement according to any one of the preceding claims with an analog or digital Hall sensor for forming a sensor circuit arrangement.

8. Serial test operating method with a circuit arrangement according to any one of the preceding claims, in which not only external data (d), but also an external clock signal (T) are modulated on a supply voltage (VDD) for transmission in the circuit arrangement.

9. Method according to claim 8, in which the data (d) and the clock signal (T) are modulated on the supply voltage (VDD) in such a manner that one of the two voltage levels (V2, V3) is exceeded or fallen below by each second flank of a clock period of the clock signal (T), wherein the intermediately disposed clock flanks lead the supply voltage (VDD) to a voltage level between the two voltage levels (V2, V3).

10. Method according to claim 8 or claim 9, in which activation of a test operating mode is signalled by means of a predetermined bit sequence (X).

## Revendications

1. Circuit avec
une interface de test (TIF) sériel pour lancer un mode de test sériel,
un processeur numérique librement programmable (CPU),
un boîtier (G) destiné à contenir l'interface de test (TIF) et le processeur (CPU) et des contacts de raccordement (C0, C1) pour un échange de données et/ou de signaux avec des composants et des dispositifs externes,
dans lequel un premier contact de raccordement (C0) est alimenté avec une tension de base (V0) et un deuxième contact de raccordement (C1) est alimenté avec une tension d'alimentation (VDD),
dans lequel il est prévu un premier comparateur (K1) avec deux entrées et un deuxième comparateur (K2) avec deux entrées, et
la tension d'alimentation (VDD) présente un niveau de tension d'alimentation (V1) pour alimenter le circuit avec une tension de fonctionnement du circuit,
dans lequel la tension d'alimentation (VDD) peut être modulée pour transmettre des données (d) et une fréquence (T) en utilisant au moins deux niveaux de tension (V2, V3),
les deux niveaux de tension (V2, V3) présentent un niveau de tension plus élevé que le niveau de tension d'alimentation (V1),
la tension d'alimentation modulable (VDD) est appliquée via une chaîne de résistances à l'entrée positive du premier comparateur (K1) et à l'entrée positive du deuxième comparateur (K2), et
une tension de référence est appliquée à l'entrée négative du premier comparateur (K1) et à l'entrée négative du deuxième comparateur (K2).

2. Circuit selon la revendication 1, dans lequel le franchissement vers le haut et/ou vers le bas des deux niveaux de tension (V2, V3) peut être détecté au moyen d'au moins les deux comparateurs (K1, K2).

3. Circuit selon la revendication 1 ou 2, dans lequel aussi bien des données (d) modulées sur la tension d'alimentation (VDD) que des données internes (d*) pour le circuit qu'une fréquence (T) modulée sur la tension d'alimentation (VDD) qu'une fréquence interne (T*) pour le circuit peuvent être extraites au moyen d'un circuit de comparateur (K).

4. Circuit selon la revendication 3, dans lequel la fréquence interne (T*) est utilisée dans un mode de test par le circuit ou des composants du circuit.

5. Circuit selon une revendication précédente, avec un dispositif de commutation (SW) pour activer un circuit de comparateur (K) et/ou l'interface de test (TIF) uniquement dans un mode de test.

6. Circuit selon la revendication 5 avec un dispositif de mémoire (M) pour stocker des états de base en vue de l'activation automatique du mode de test après une connexion et/ou une mise en service du circuit.

7. Circuit selon une revendication précédente avec un capteur de Hall analogique ou numérique pour former un circuit de capteur.

8. Procédé à mode de test sériel avec un circuit selon une revendication précédente, dans lequel aussi bien des données externes (d) qu'une fréquence externe (T) sont modulées sur une tension d'alimentation (VDD) pour la transmission dans le circuit.

9. Procédé selon la revendication 8, dans lequel les données (d) et la fréquence (T) sont modulées sur la tension d'alimentation (VDD), de telle manière qu'un des deux niveaux de tension (V2, V3) soit franchi vers le haut et/ou vers le bas avec chaque deuxième flanc d'une période élémentaire de la fréquence (T), dans lequel les flancs de période situés entre ceux-ci conduisent la tension d'alimentation (VDD) à un niveau de tension entre les deux nivaux de tension (V2, V3).

10. Procédé selon la revendication 8 ou la revendication 9, dans lequel on signale une activation d'un mode de test au moyen d'une séquence de bits prédéterminée (X).
